# EUROPEAN PATENT SPECIFICATION

(11) **EP 2 865 007 B1**
(45) Date of publication and mention of the grant of the patent: **20.11.2019**
(21) Application number: 13740206.1
(22) Date of filing: 25.06.2013
(51) Int. Cl.: H01L 27/115, C23C 14/08, C23C 16/40, G11C 11/56, H01L 21/02, H01L 49/02, G11C 11/22

(54) **FERROELECTRIC MEMORY DEVICE AND MANUFACTURING METHOD THEREOF**
FERROELEKTRISCHE SPEICHERVORRICHTUNG UND HERSTELLUNGSVERFAHREN DAFÜR
DISPOSITIF MÉMOIRE FERROÉLECTRIQUE ET SON PROCÉDÉ DE FABRICATION

(30) Priority: 25.06.2012 GB 201211267
(43) Date of publication of application: 29.04.2015
(73) Proprietor: Frantti, Johannes, Helsinki 00180 (FI); Fujioka, Yukari, Helsinki 00180 (FI)
(72) Inventor: Frantti, Johannes, Helsinki 00180 (FI); Fujioka, Yukari, Helsinki 00180 (FI)
(74) Representative: Norris, Timothy Sweyn
(86) International application number: PCT/EP2013/001855
(87) International publication number: WO 2014/000880

(56) References cited:
- WO-A1-2006/059955
- US-A1- 2005 072 996
- US-A1- 2010 221 415
- J. Y. Li ET AL: "Domain switching in polycrystalline ferroelectric ceramics", Nature Materials, vol. 4, no. 10, 18 October 2005 (2005-10-18), pages 776-781, XP055079341, ISSN: 1476-1122, DOI: 10.1038/nmat1485
- By S A Mabud: "The Morphotropic Phase Boundary in PZT Solid Solutions", J. Appl. Cryst, vol. 13, no. 211, 1 January 1980 (1980-01-01), page 216, XP055486487,

## Description

### Field of the invention

The present invention relates to memory devices, for example to microfabricated memory devices based upon ferroelectric materials, for example Lead Zirconate Titanate (PZT) materials. Moreover, the present invention is also concerned with methods of microfabricating aforesaid memory devices. Furthermore, the present invention is concerned with use of ferroelectric materials in microfabricating electronic devices, for example microfabricated memory devices.

### Background of the invention

Known memory devices such as static random access memories (SRAM) and dynamic random access memories (DRAM), manufactured by way of Silicon microfabrication processes, are operable to store data in a volatile manner, namely data is lost when power supply to the SRAM and DRAM is interrupted. Electrically erasable programmable random access memory (EEPROM), also commonly known as "flash memory", enables non-volatile data storage to be achieved by way of electrical charge being stored in an insulated floating electrode structure forming a capacitor cell. Such EEPROM's can be reprogrammed multiple times, but data storage is time consuming because electrons are transferred to, or removed from, the insulated floating electrode structure via electron tunnelling process. There therefore arises a contemporary need for high capacity non-volatile memory that can be read and written more rapidly.

More recently, it has been appreciated that non-volatile semiconductor devices can be microfabricated by employing a combination of Silicon microfabrication processes and ferroelectric materials. For example, in a granted United States patent no. US 7, 057, 221 B2 ("Semiconductor Memory Device", inventors - Takashima & Toshiba), there is described a semiconductor memory device comprising a ferroelectric element, wherein an electric field applied to the ferroelectric element is controlled to shift relatively a position of a first atom with respect to a position of another atom and thereby to store data at stabilized positions as remnant polarizations, and wherein the ferroelectric element stores two-bit information by having a total of four stabilized positions of the first atom; the four stabilized positions include a first stabilized two positions in a first spatial direction, and a second stabilized two positions in a second spatial direction, wherein the first and second directions are mutually different and mutually perpendicular. Optionally, the ferroelectric element is fabricated from a ferroelectric material which has an ABO₃ crystal structure. The ABO₃ Perovskite structure is composed of atoms A, atoms B and atoms O; an electric field applied to the ferroelectric element is controlled in operation so that a position of each of the atoms B is shifted relative to spatial positions of the atoms A and atoms O to store data at the stabilized positions as remnant polarizations. It is thereby alleged to be feasible to store two-bit information by having a total of four positions of the atoms B, wherein, as aforementioned, the positions include first stabilized two positions in a first spatial direction, and second stabilized two positions in a second spatial direction which is perpendicular to the first spatial direction.

In the aforesaid granted United States patent no. US 7, 057, 221 B2, there is described a memory device, wherein an operation of shifting atoms B of a ferroelectric element to six possible positions is achieved by applying a suitably orientated electric field generated by way of six electrodes arranged around the ferroelectric element.

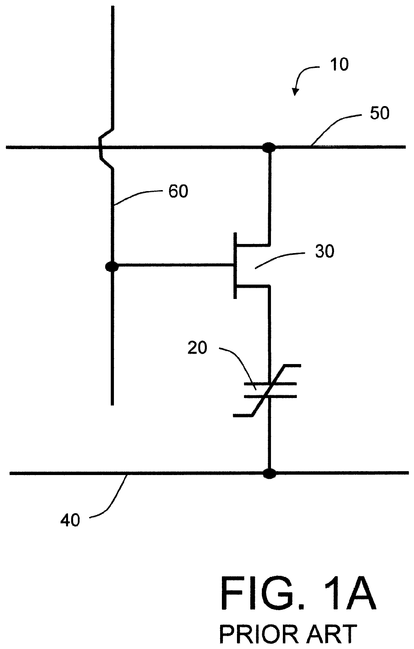

Aforesaid EEPROM and associated flash memory can be erased and re-programmed multiple times, but such activities require relatively high voltages and occur relatively slowly. In contradistinction, memory devices based upon ferroelectric elements are capable of providing about 10000 times more endurance than an EEPROM and associated flash memory, consuming 3000 times less power when in operation than an EEPROM, and providing 500 times faster writing speed when in operation than an EEPROM. An example proprietary known memory device based upon ferroelectric elements makes use of Lead Zirconate Titanate (PZT) ceramic material having a chemical composition Pb(Zrₓ, Ti₁₋ₓ)O₃, thought to be a tetragonal Titanium-rich solid-solution ceramics material. Referring to FIG. 1A, a circuit of a known ferroelectric memory cell is indicated generally by **10** and includes a non-volatile ferroelectric capacitor **20** coupled to a field effect transistor (FET) **30.** A first plate of the capacitor **20** is coupled to a plate enable line **40.** A second plate of the capacitor **20** is coupled via the FET **30** to a bit lane **50.** A gate of the FET **30** is coupled to a word line **60.** The FET **30** controls reading and writing of data from the capacitor **20.**

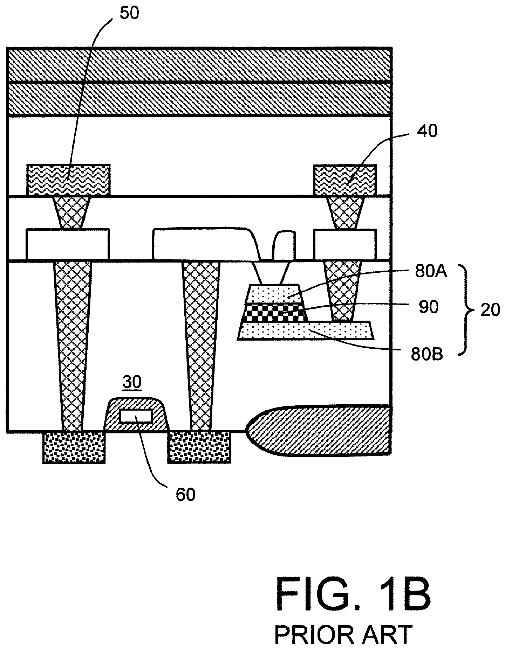

In practice, the memory cell **10** is microfabricated by way of a structure which is illustrated in FIG. 1B in cross-section. The capacitor **20** is fabricated by way of a ferroelectric element **90** with first and second electrodes **80A, 80B** abutting thereto, wherein the electrodes **80A, 80B** are mutually coupled via the ferroelectric element **90.** During microfabrication, the ferroelectric element **90** is formed by vacuum deposition methods in combination with photolithography and ion milling or similar vacuum techniques. Characteristics of the ferroelectric element **90** are highly significant in defining an operating performance of the memory cell **10.** The memory cell **10** in FIG. 1A and FIG. 1B is capable of providing for logic 0 and logic 1 data storage.

Although aforesaid memory devices based upon ferroelectric elements are capable of providing an improvement in comparison to conventional EEPROM and associated flash memory devices, there is a desire to increase a spatial density of memory cells in a memory device based upon ferroelectric elements. Such an increase in spatial density represents a technological problem which has not been adequately addressed in the known art.

US 2005/0072996 A1 discloses a memory device comprising ferroelectric thin films in which 180° domains and 90° domains arrange at a constant angle to an applied electric field direction.

Known literature pertaining to ferroelectric materials and technology are provided in appended APPENDIX 1 for reference.

### Summary of the invention

The present invention seeks to provide a memory device including a plurality of ferroelectric memory elements which has a greater spatial density of memory cells. The present invention seeks to provide a method of fabricating a memory device including a plurality of ferroelectric memory elements which has a greater spatial density of memory cells.

According to a first aspect of the present invention, there is provided a memory device as claimed in appended claim 1.

The invention is of advantage in that use of ferroelectric elements having a plurality of co-existing states is capable of enabling a greater spatial density of memory cells to be achieved.

According to the invention, in the memory device, the at least one ferroelectric element is fabricated from Lead Zirconate Titanate material whose composition corresponds to a morphotropic phase boundary composition. In the memory device, the Lead Zirconate Titanate material has a composition Pb(ZrₓTi₁₋ₓ)O₃, wherein a parameter x is in a range of 0.52 to 0.56.

Optionally, in the memory device, the at least one ferroelectric element is provided with an electrode arrangement which enables the at least one ferroelectric element to store a plurality of bits of data therein.

According to the invention, in the memory device, the at least one ferroelectric element is grown upon a substrate layer exposed to the at least one ferroelectric element, wherein the substrate layer is chosen to avoid misfit strain with the ferroelectric material employed to fabricate the at least one ferroelectric element. According to the invention, in the memory device, the substrate layer is Gd₃Ga₅O₁₂ which is grown to expose a (110) crystal plane towards the at least one ferroelectric element. More optionally, in the memory device, the at least one ferroelectric element is fabricated from a material having a composition of substantially Pb(Zr_{0.54}Ti_{0.46})O₃. Yet more optionally, in the memory device, the substrate layer is formed upon a single-crystal Silicon wafer substrate.

In one example not forming part of the invention, in the memory device either a layer of SrZrO₃ material is grown onto the substrate, or the substrate is fabricated from SrZrO₃ material, to expose a (100) crystal plane towards the at least one ferroelectric element to minimize a misfit strain arising between the Lead-Zirconate-Titanate layer and substrate.

Optionally, in the memory device, the at least one ferroelectric element has a thickness in a range of 30 nm to 250 nm. More optionally, in the memory device, the at least one ferroelectric element has a thickness in a range of 50 nm to 150 nm.

Optionally, in the memory device, the at least one ferroelectric element is fabricated from a material which is substantially pore-free. By "substantially *pore-free"* is optionally meant more than 90% pore-free.

According to a second aspect of the present invention, there is provided a method of fabricating a memory device for storing data, as claimed in appended claim 5.

According to the invention, the method includes fabricating at least one ferroelectric element from Lead Zirconate Titanate material whose composition corresponds to a morphotropic phase boundary composition. The method includes fabricating the Lead Zirconate Titanate material from a composition Pb(ZrₓTi₁₋ₓ)O₃, wherein a parameter x is in a range of 0.52 to 0.56.

Optionally, the method includes fabricating at least one ferroelectric element to be provided with an electrode arrangement which enables the at least one ferroelectric element to store a plurality of bits of data.

According to the invention, the method includes growing the at least one ferroelectric element upon a substrate layer exposed to the at least one ferroelectric element, wherein the substrate layer is chosen to avoid misfit strain with the ferroelectric material employed to fabricate the at least one ferroelectric element. According to the invention, the method includes utilizing a substrate layer of Gd₃Ga₅O₁₂ which is grown to expose a (110) crystal plane towards the at least one ferroelectric element. More optionally, the method includes fabricating the at least one ferroelectric element from a material having a composition of substantially Pb(Zr_{0.54}Ti_{0.46})O₃. More optionally, the method includes forming the substrate layer upon a single-crystal Silicon wafer substrate.

Optionally, the method includes fabricating the at least one ferroelectric element to have a thickness in a range of 30 nm to 250 nm. More optionally, the method includes fabricating the at least one ferroelectric element to have a thickness in a range of 50 nm to 150 nm.

In one example not forming part of the invention, the method includes fabricating at least one ferroelectric element from a material which is substantially pore-free. In other examples not forming part of the invention, the method includes employing chemical deposition and/or physical deposition processes to deposit the material of the at least one ferroelectric element. In yet more examples, the chemical deposition processes include sol-gel deposition. In other examples, the physical deposition processes include at least one of: vacuum deposition, magnetron sputtering.

In one example not forming part of the invention, the method includes fabricating the at least one ferroelectric element to include substantially equal amounts of rhombohedral and monoclinic phases.

It will be appreciated that features of the invention are susceptible to being combined in various combinations without departing from the scope of the invention as defined by the appended claims.

### Description of the diagrams

Embodiments of the present invention will now be described, by way of example only, with reference to the following diagrams wherein:
- FIG. 1A: is an illustration of an equivalent circuit of a known memory cell based upon a ferroelectric element;
- FIG. 1B: is an illustration in cross-section of a microfabricated implementation of the equivalent circuit of FIG. 1A;
- FIG. 2A to FIG, 2H: are schematic illustrations of pyroelectric and ferroelectric characteristics of materials;
- FIG. 3: is an illustration of grain boundaries in a ferroelectric material employed to implement a memory cell;
- FIG. 4: is an illustration of hysteresis characteristics of a ferroelectric material;
- FIG. 5: is a phase diagram for Lead Zirconate Titanate (PZT) material;
- FIG. 6A to FIG. 6C: are schematic illustrations of memory cells pursuant to the present invention;
- FIG. 7: is a schematic illustration of a portion of a memory device pursuant to the present invention; and
- FIG. 8: is a schematic illustration of an example of changes occurring at a primitive cell level, wherein the changes pertain to a shift in oxygen octahedra with respect of A-cations in Perovskites.

In the accompanying diagrams, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

### Description of embodiments of the invention

In overview, the present invention is concerned with an improved memory device including a plurality of memory cells including corresponding ferroelectric elements, wherein the ferroelectric elements are fabricated using an advantageous ferroelectric material, namely a Lead Zirconate Titanate (PZT) material having a composition Pb(Zrₓ Ti₁₋ₓ)O₃, wherein a parameter x is in a range of 0.52 to 0.56. Such a range corresponds to a morphotropic phase boundary (MPB) composition, wherein characteristics of this composition are that it includes approximately equal amounts of rhombohedral, namely space group *R*3c, and monoclinic, namely space group *C*m, phases. Moreover, the monoclinic phase is beneficially a slightly distorted version of a tetragonal phase, which can be considered as being metrically close to a tetragonal structure.

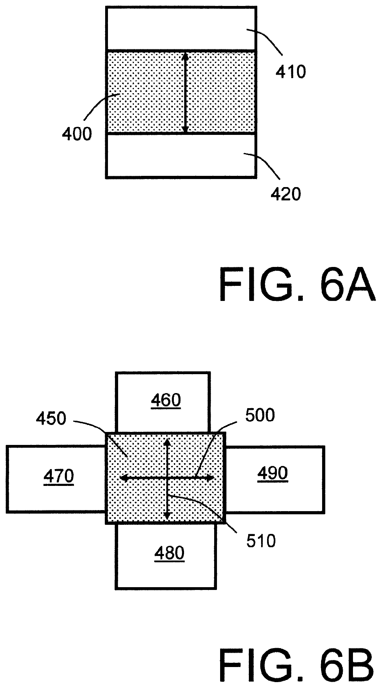

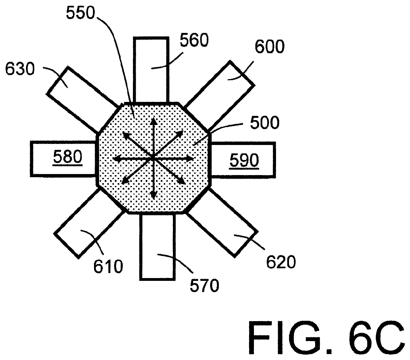

For example, in respect of materials in a state of solid-solution, one or more given space group symmetries often refer to one or more long-range averages. In a short-range scale, a spatially local symmetry often deviates significantly from corresponding a long-range average. This was recently demonstrated in the publication by J. Frantti, Y. Fujioka, A. Puretzky, Y. Xie, Z.-G. Ye, and A. M. Glazer, in the Journal of Applied Physics, vol. 113, 174104 (2013), as provided in Appendix 1 below. Such a deviation is essentially due to the dependence of Pb-ions on the distribution of Zr and Ti ions near the Pb-ions under consideration. Moreover, such a deviation is illustrated in a Fig. 6 and a Table VIII in the aforementioned Frantti et al. reference in the Journal of Applied Physics, vol. 113, 174104 (2013). In essence, the number of accessible states in a local scale is vast, especially in the vicinity of the MPB as is demonstrated in the aforementioned Frantti *et al.* paper.

The aforementioned two phases co-exist in the advantageous ferroelectric material and have a crucial role for polarization switching in a memory cell based upon one or more ferroelectric elements. When considering domain switching in the advantageous ferroelectric material, it has been found that 90° domains in a single-phase tetragonal phase, namely a Titanium-rich PZT, hardly switch in response to a given applied electric field, whereas domains in the two-phase region of the advantageous ferroelectric material are capable of switching, for example for data storage purposes in a data memory device. Texture and strain analysis of the ferroelastic behaviour of a material Pb(Zr_{0.49}Ti_{0.51})O₃ by *in-situ* neutron diffraction techniques has identified that a rhombohedral phase of the material plays a significant role in a macroscopic electromechanical behaviour of the material.

Moreover, for clarification, the term *"morphotropic phase boundary"* (MPB) often refers to a nearly vertical, namely temperature T independent, phase boundary separating rhombohedral and tetragonal phases in the x-T phase diagram of the compound Pb(ZrₓTi₁₋ₓ)O₃. Since the rhombohedral and tetragonal phases do not have a group-subgroup relationship, the transition between the rhombohedral and tetragonal phases, following a first order transition, further implies a two-phase co-existence region. Thus, the mentioned *'morphotropic'* part of MPB has no bearing on the external shape of the material, and it specifically does not refer to the morphology. MPB is used to refer to the specific composition range in the vicinity of the phase transition, wherein the parameter x is substantially in a range of 0.47 to 0.56 for PZT material. For example, many other Perovskite solid-solutions, such as yPb(Mg_{1/3}Nb_{2/3})O_{3-(1-y)}PbTiO₃, with parameter y approximately around 0.3 possess a MPB property.

By employing the aforementioned range for the parameter x to make a ferroelectric element, such a range enables the element to change polarization of its structure between positive and negative *a*-axis, *b*-axis and *c*-axis, as well as in a diagonal manner within a basic element, namely parallel epiped, of the material used to fabricate the element. Such beneficial characteristics enable an N-state ferroelectric memory cell to be fabricated on account of polarization changes being possible in all directions of the cell; beneficially N can be greater than two. Thus, the present invention is concerned with a polycrystalline multidomain ferroelectric material operating in a vicinity of a phase transition; by such operation, a plurality of accessible polarization states, corresponding to a plurality of spatial directions of polarizations, is achievable. Moreover, in such a material, polarization reversal occurs easily which enables memory devices to be fabricated which are capable of functioning on relatively lower voltage supplies.

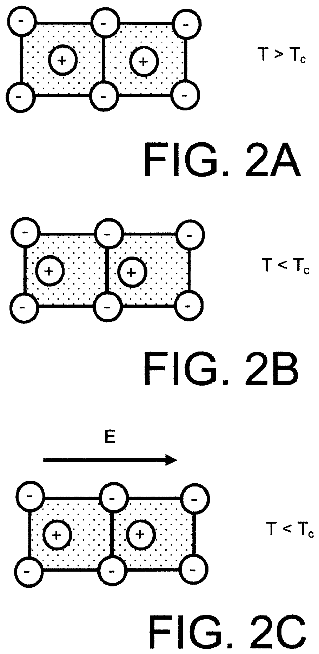

In order to elucidate the present invention in a manner which will be understood to a person skilled in the art, some basic definitions pertaining to ferroelectricity and ferroelectric materials will now be provided. In FIG. 2A to FIG. 2H, there is shown a depiction of pyroelectric and ferroelectric phenomena. Pyroelectricity is a phenomenon found in crystals which possess a permanent electric dipole moment as a result of a relative spatial disposition of their atoms. The magnitude of the moment depends upon temperature; this temperature dependence enables the dipole moment to be observed experimentally. Considerations of symmetry dictate that pyroelectricity can only occur in ten crystal classes, namely 6*mm,* 4*mm* and their associated subgroups 6, 4, 3*m*, *mm*2*,* 2, *m* and 1. All these classes of crystal are piezoelectric. For piezoelectric materials, there exists a Curie temperature T_{c} above which any imposed polarization on piezoelectric material is lost. In certain cases, the crystals of piezoelectric material melt before the, in such a case hypothetical, Curie temperature T_{c} is reached. Ferroelectric crystals are materials in which a direction of a permanent electric dipole moment can be changed by applying an electric field, thereby enabling the crystals to form a basis of a memory device.

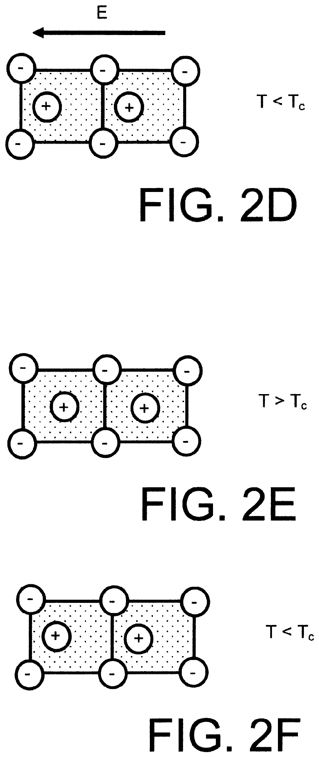

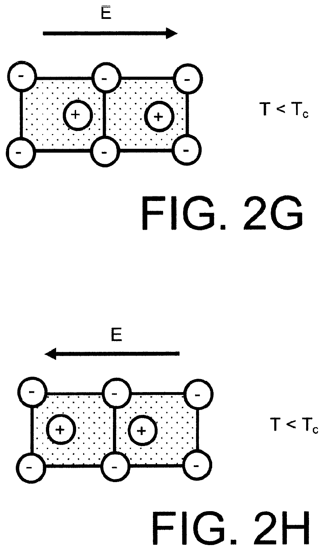

In FIG. 2A to FIG. 2D, there is depicted a pyroelectric effect. In FIG. 2E to FIG. 2H, there is depicted a ferroelectric effect. An essential point distinguishing non-ferroelectric pyroelectric materials from ferroelectric pyroelectric materials is appreciated by noting that an applied electric field is not capable of switching a polarization direction in the first mentioned case, namely as illustrated in FIG. 2C and 2D, whereas in ferroelectrics there are at least two states between which an applied electric field can switch, namely as illustrated in FIG. 2G and 2H. In FIG. 2A, a piezoelectric material has a crystal structure denoted by "-" and "+" to indicate spatial polarization; the material has a temperature T which is above the Curie temperature T_{c}, resulting in no dipole moment denoted in a symmetrical placement of the "+" symbol. However, in FIG. 2B, when the temperature T is below the Curie temperature T_{c}, the material exhibits a permanent dipole moment, denoted by the "+" symbol being relatively displaced in a left direction relative to FIG. 2A; this permanent dipole moment is formed spontaneously in an individual crystal as it is cooled below the Curie temperature T_{c}. However, macroscopic materials are usually divided into domains which are each polarized. The net polarization of all domains is usually zero, unless an electric field or stress is applied while the material is cooled from above the Curie temperature T_{c} to below the Curie temperature T_{c}, namely by way of a poling process. As illustrated in FIG. 2C and FIG. 2D, when the temperature T of the material is below the Curie temperature T_{c}, the material maintains its polarisation irrespective of a direction of an applied electric field E.

In FIG. 2E, a ferroelectric material is heated to a temperature above its Curie temperature T_{c}; the ferroelectric material then loses net dipole moment as depicted by central placement of the symbol "+". In FIG. 2F, the ferroelectric material is capable of being polarized to impart a permanent dipole moment thereto, as denoted by the "+" symbol being displaced to a left side relative to FIG. 2E. However, when the ferroelectric material is lower in its temperature T than the Curie temperature T_{c}, a dipole moment of the ferroelectric material can be permanently established as illustrated in FIG. 2F; moreover, the dipole moment of the ferroelectric material can be switched between two states as illustrated in FIG. 2G and FIG. 2H by applying a sufficiently strong electric field E across the ferroelectric material. Depending upon a crystal symmetry pertaining, the number of states between which an electric field induced transition can occur can be larger than two. For example, in crystals having tetragonal and rhombohedral symmetries, the number of accessible states are six and eight, respectively.

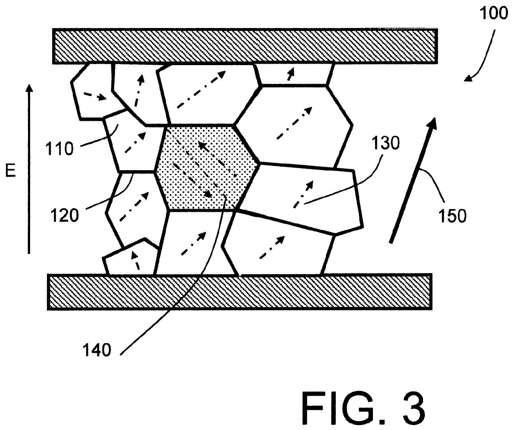

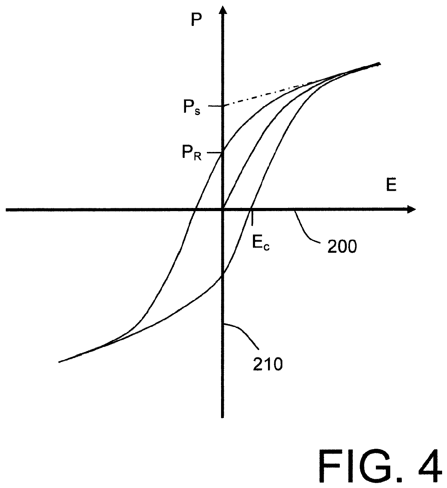

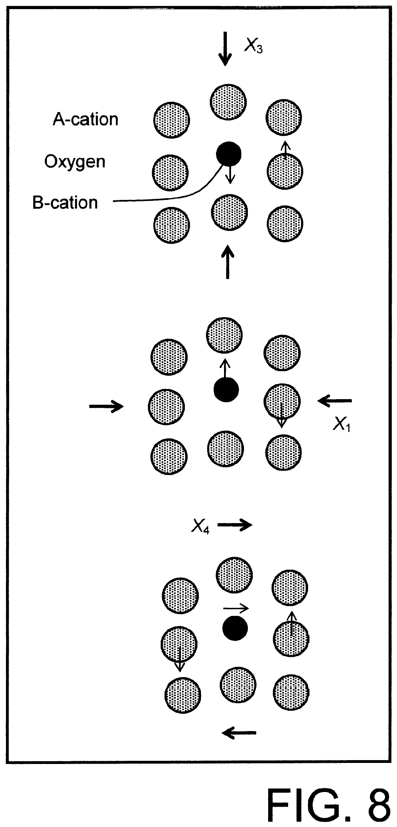

Ferroelectric materials exhibit aforesaid dipole moments by changes occurring at a primitive cell level and also in a larger scale associated with motions of domain and grain boundaries. Referring to FIG. 3, there is provided an illustration of a polycrystalline material indicated by **100** consisting of grains **110,** denoted by a grey dotted polygon, of material which are mutually separated by grain boundaries **120.** Each grain **110** often includes several domains, which are crystalline volumes with uniform polarization **130,** except for the domain boundary region. Domains are separated by domain walls **140.** When a stimulus is applied in a form of an electric field, the stimulus results in changes in grain boundaries and associated domain wall motion. Changes in grain boundaries and associated domain wall motion are examples of extrinsic changes occurring in the material **100.** However, each domain includes a plurality of primitive cells, wherein the primitive cells themselves can also be changed by the aforesaid stimulus. An example of changes occurring at a primitive cell level is a shift in Oxygen octahedra with respect of A-cations in Perovskites, for example as illustrated in FIG. 8. Thus, a nature of a sample structure is capable of significantly influencing its response to an external influence, for example an applied electric field E, wherein the nature can pertain to poled polycrystalline ceramics and non-twinned single crystals. Thus, the net polarization **150** of a material is influenced by the domain distribution. Domain wall motion requires energy, which is directly proportional to the area of the hysteresis loop, namely as illustrated in FIG. 4.

In order to understand ferroelectric material response to applied stimulus, it is necessary to determine a texture present in the material; such determination identifies variously orientated domains which respond to external stimulus, for example to an applied electric field. After the texture, namely preferred orientation, is known, it is feasible to determine angular averages of piezoelectric constants of the material. For example, electrically-poled ceramics belong to a symmetry group ∞ *m*, even though individual crystals can have a lower symmetry, for example 4*mm* or 3*m*. It is also necessary to understand intrinsic characteristics of changes in electric polarization within a domain in response to an applied external stimulus, for example to an applied electric field. Referring again to FIG. 3, different polarization contributions of the grains **110,** namely spatially local polarizations, denoted by dashed arrows, results in a net aggregate polarization denoted by an arrow **150,** namely "long range" polarization. When stress is applied to the material **100,** an effect of the stress is transmitted via the grains **110.** Each grain **110,** in turn, is sub-divided into domains.

Small quantities of energy are required, for example in the form of applied heat, to cause significant changes in phase transitions of grains **110** when they are manufactured from a material which is near its first-order phase transition. Such phenomena are observed, for example, in PZT powders having a composition at a MPB region by way of phase fraction changes of (pseudo-)tetragonal, strictly speaking, monoclinic, and rhombohedral phases as a function of temperature. A two-phase co-existence occurs in the vicinity of the MPB; moreover, in the Zirconium-rich side of the MPB, the phase transition between monoclinic and rhombohedral is of a first order. It is believed that there are regions in which rhomobohedral and monoclinic crystals have grown together. Moreover, such a phase transformation is significant for understanding piezoelectric responses of PZT materials.

It is found that domain boundary motion can, at least to a limited extent, be controlled by employing doping when manufacturing piezoelectric materials. For example, in polarisable ceramic materials, a large fraction of energy required for achieving polarisation is consumed for inducing domain wall motion. Depending upon desired application, a composition of the ceramic material is selectively manufactured so that a coercive field for the material is either large, namely as for a hard ferroelectric material, or small, namely as for a soft ferroelectric material. A coercive field is a measure describing a threshold at which a polarisation direction present in the material can be reversed. In PZT materials, domain wall motions are controlled by doping with higher-valent or lower-valent ions; for example, a hard PZT can be manufactured by doping PZT with Iron (Fe) ions, wherein a Iron Fe³⁺ ion substitutes for a Titanium Ti⁴⁺ ion, namely acts as an acceptor; for example, a soft PZT can be manufactured by doping PZT with Lanthanum or Neodymium ions, namely La³⁺ and Nd³⁺ substitutes for Lead Pb²⁺, namely acts as a donor. Controlling a concentration and spatial position of dopants in PZT is thus crucial when fabricating memory devices based upon ferroelectric materials; it makes a considerable difference if dopants are segregated at grain boundaries or if they are homogeneously distributed in the ferroelectric materials. Referring to FIG. 4, there is shown a graph including an abscissa axis **200** denoting applied electric field *E* and an ordinate axis **210** denoting polarisation of domains *P* in a given soft ferroelectric material; the graph illustrates hysteresis characteristics of polarisation for the given soft ferroelectric material. Such a soft ferroelectric material exhibits a relatively low value of coercive field *E_{c}.* In comparison, hysteresis characteristics of a hard ferroelectric material result in a larger hysteresis loop on the graph with more rectilinear shape. In FIG. 4, PR and PS correspond to remnant polarisation and to the polarization values extrapolated from large field values to zero applied electric field *E,* respectively. Moreover, a manner in which the electrodes are located with respect to the ferroelectric material has crucial importance for polarization reversal. A depolarization factor is unity for a plate when the applied electric field is perpendicular to the plate, whereas the depolarization factor is zero for a plate when the applied electric field is in-plane. This factor favours in-plane geometries, because it enables smaller applied voltages to be applied in operation. The depolarization factor depends upon geometry and describes to what extent material can diminish the applied electric field inside the material.

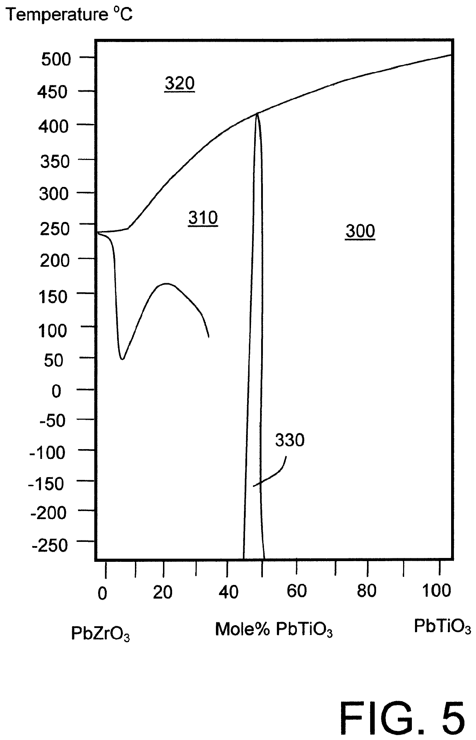

Contemporary ferroelectric memory devices employ a single phase of Lead Zirconate Titanate (PZT) ferroelectric material having a composition Pb(Zrₓ Ti₁₋ₓ)O₃, wherein x is parameter. However, in respect of the present invention, it has been appreciated that the number of polarisation directions that are feasible to achieve in a ferroelectric material can be increased significantly by adjusting the parameter x so the ferroelectric material is close to a phase boundary, namely PZT has a Perovskite *ABO*₃ crystal structure which changes at its phase boundary between tetragonal *P*4*mm* form to rhombohedral *R*3*m* form or *R*3*c* form. The *P*4*mm* form is represented by low-temperature and Titanium-rich areas **300** in FIG. 5, the *R*3*m* form and *R*3*c* form are represented by low-temperature and Zirconia-rich areas **310** in FIG. 5. At elevated temperatures, the ferroelectric material transforms to a paraelectric cubic phase **320.**

An area **330** in FIG. 5 corresponds to an MPB area wherein two co-existing phases are possible. A monoclinic phase C*m* occurs for parameter × > 0.50; the C*m* phase is a slightly distorted version of the tetragonal phase *P*4*mm.* The C*m* phase is feasible to achieve on account of there arising local defects in practice, for example such as an inhomogeneous spatial distribution of Zirconia and Titanium ions. Moreover, the Cm is not a truly stable phase. For ferroelectric memory devices pursuant to the present invention, it is desirable that ferroelectric elements employed for memory cells of such devices are fabricated from, namely comprise, ferroelectric materials which are in a vicinity of their morphotropic phase boundary, namely where there arises a two-phase coexistence which results in a large number of accessible polarisation states. Furthermore, in an area of two-phase co-existence, the electric field *E* required for reversing a recorded polarization state in a given ferroelectric element is smaller, namely resulting in the memory devices being capable of being operated at relatively lower memory device supply voltages.

Ferroelectric materials for fabricating memory devices include a plurality of ferroelectric elements. The ferroelectric elements are beneficially formed using chemical deposition, for example sol-gel deposition, or physical techniques, for example vacuum deposition, magnetron sputtering deposition or laser-ablation deposition. It is important that ferroelectric film homogeneity, stoichiometry and thickness are carefully controlled during deposition so that the film exhibits morphotropic phase boundary (MPB) characteristics. Moreover, it is desirable that the ferroelectric film should be crystalline and dense, namely substantially devoid of pores, namely controlled by careful adjustment of temperature during deposition for example. For example, it is desirable that processing temperature is controlled in a range of 300 °C to 700 °C during deposition of the ferroelectric film used for fabricating the ferroelectric elements. Thereafter, photolithographic process can be employed to delimit the film spatially to generate the plurality of ferroelectric elements, for example by employing photoresist and vacuum-based ion milling processes. Optionally, the ferroelectric film employed for fabricating the plurality of ferroelectric elements has a thickness in a range of 30 nm to 250 nm, more optionally in a range of 50 nm to 150 nm, and yet more optionally substantially 100 nm. The ferroelectric film beneficially has a chemical composition Pb(Zrₓ Ti₁₋ₓ )O₃, wherein a parameter x is in a range of 0.52 to 0.56, namely corresponding to a morphotropic phase boundary (MPB) composition. Such choice of the parameter x is capable of providing a ferroelectric material for fabricating the ferroelectric elements which includes approximately equal amounts of rhombohedral phase, namely space group *R*3*c* phase, and monoclinic phases, namely space group C*m* phases. The monoclinic phase, as aforementioned, is a slightly distorted version to the tetragonal phase, and can be regarded for practical purposes as being substantially tetragonal.

The two-phase co-existence of the ferroelectric film has a crucial role for polarization switching in memory device pursuant to the present invention. It has been found that 90° domains in single phase tetragonal phases, namely Titanium-rich PZT, hardly switch, whereas the domains in the two-phase region employed for implementing the present invention readily switch. Example of similar materials, or additional materials to PZT, which could be used comprises of *y*Pb(Mg_{1/3}Nb_{2/3})O₃-(1-*y*)PbTiO₃, where Mg could be replaced with, for example, with Zn or similar compounds. A common nominator for the choice of the materials is that all have phase boundary characteristics which are like MPB, and both phases exists at the same time.

The rhombohedral phase in the ferroelectric film plays a significant role in the macroscopic behaviour of the film. Thus, the aforesaid x range of values for the ferroelectric film enables its polarisation to be switched between *c*-axis, *b*-axis and *a-*axis directions as well as in one or more diagonal directions within a cube of the ferroelectric material. Such a flexible polarisation direction of the ferroelectric film enables memory cells of the memory device pursuant to the present invention to function as *N*-state ferroelectric memory cells, on account of polarisation changes being potentially possible in all polarisation directions of the memory cell. It is thus feasible to achieve potentially greater data storage density in the memory device, compared to contemporary memory devices, as well as data writing and reading using less power and lower operating voltages. To increase the number of domains in a given volume, thinner films can be deposited when fabricating memory devices pursuant to the present invention. It is possible to show by thermodynamical considerations that the domain width is proportional to the square root of the film's thickness.

Practical embodiments of the present invention will now be described. In FIG. 6A, a 1-bit memory cell can be fabricated by including a ferroelectric element **400** between upper and lower electrodes **410, 420** respectively; such a structure of 1-bit memory cell is employed in known ferroelectric memory devices, wherein the ferroelectric element is a single-phase ferroelectric material. Beneficially, when implemented pursuant to the present invention, the ferroelectric element is fabricated from ferroelectric material exhibiting a two-phase co-existence. For example, when a positive voltage is applied to the upper electrode **410** and a negative potential, for example a ground potential, is applied to the lower electrode **420,** the ferroelectric element **400** changes its polarisation to store a bit of data; beneficially, the electrodes **410, 420** are beneficially switched via one or more field effect transistors (not shown).

In FIG. 6B, a memory cell is illustrated in which a ferroelectric element **450** is surround by electrodes **460, 480** along a first Cartesian axis, and by electrodes **470, 490** along a second Cartesian axis as illustrated, wherein the Cartesian axes are mutually perpendicular. The memory cell thereby provided is capable of storing 2 bits of data along respective polarisation directions **500, 510.** During writing and reading of data, appropriate voltages are applied to the electrodes **460, 470, 480, 490** using field effect transistors (FET) (not shown).

In FIG. 6C, a memory cell is illustrated in which a ferroelectric element **550** is surrounded by eight electrodes **560, 570, 580, 590, 600, 610, 620, 630,** wherein:
(a) the electrodes **560, 570** are included on mutually opposite sides of the element **550** and are disposed along a first Cartesian axis;
(b) the electrodes **580, 590** are included on mutually opposite sides of the element **550** and are disposed along a second Cartesian axis which is mutually perpendicular to the first axis;
(c) the electrodes **600, 610** are included on mutually opposite sides of the element **550** and are disposed along a first diagonal axis relative to the aforesaid first and second Cartesian axes; and
(d) the electrodes **620, 630** are included on mutually opposite sides of the element **550** and are disposed along a second diagonal axis which is perpendicular to the first diagonal axis.

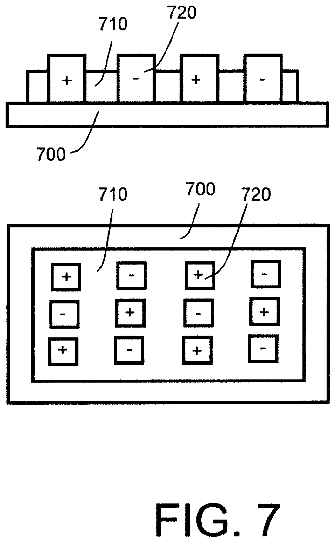

The eight electrodes **560, 570, 580, 590, 600, 610, 620, 630** are coupled to associated field effect transistors (FET) (not shown) which are used for writing and reading data from the element **550.** The memory cell in FIG. 6C is capable of storing 4 bits of data. It will be appreciated that more than eight electrodes are optionally included, which enables, for example, data corresponding to a complete 8-bit byte to be written and read from a single ferroelectric element implemented pursuant to the present invention. Optionally, electrodes can be disposed around the element **550** as well as above and below the element **550** to enable even more data to be stored in the element **550.** An example implementation of a memory cell pursuant to the present invention, based upon the use of ferroelectric elements as data storage structures, is illustrated in FIG. 7. A substrate **700** is fabricated to include a layer of Gd₃Ga₅O₁₂ (GGO) single crystal material with an <110> crystal orientation exposed at an upper surface of the substrate **700.** Such an orientation is adopted to avoid a misfit between two-phase ferroelectric material Pb(Zr_{0.54}Ti_{0.46})O₃; in other words, the chosen exposed surface lattice of GGO has a lattice spacing similar to Pb(Zr_{0.54}Ti_{0.46})O₃. However, the substrate **700** is optionally any material with a structure and lattice parameters similar to Pb(Zr_{0.54}Ti_{0.46}) O_{3.} According to the invention, the GGO is grown on any suitable substrate material, for example a single crystalline Silicon wafer or amorphous glass surface, for example by way of molecular beam epitaxy, sputter deposition or similar. However, misfit strain is beneficially to be avoided between the substrate **700** and its associated layer of Gd₃Ga₅O₁₂ (GGO) single crystal material. A layer **710** of ferroelectric material Pb(Zr_{0.54}Ti_{0.46})O₃ is then deposited onto the GGO layer, wherein the layer **710** of ferroelectric material beneficially has a thickness in a range of 30 nm to 250 nm, and more preferably in a range of 50 nm to 150 nm. A larger domain density is achievable in the ferroelectric layer **710** as the layer **710** is made thinner during deposition. The layer **710** is then delineated using photolithographic techniques with associated etching to remove material selectively from the layer **710.** Thereafter, electrodes **720** are formed into regions where the layer **710** has been selectively removed. Thereafter, the electrodes **720** are coupled to corresponding field effect transistors (FET) (not shown) which enable data to be written and read from the layer **710.** Data is stored by way of one or more polarization directions of the ferroelectric material present in regions between the electrodes **720.**

When fabricated, the substrate **700** is diced to provide individual chips which are then mounted onto one or more headers, wires attached to the chips and then hermetically sealed to provide user-chips or modules, for example for use in computers, mobile telephones ("cell phones"), electronic apparatus, electronic musical instruments, memory units, neural network simulations of the human brain and similar. Optionally, additional components are included in the substrate to form a high-speed data processor with data memory pursuant to the present invention distributed about the processor. Processor clocking speeds in an order of ten's of GHz are thereby potentially feasible to achieve.

The present invention is pertinent to ferroelectric memory devices employed in solid-state mass data storage devices capable of low power operation and rapid read/write speed, for example for surveillance systems, video data storage and similar. Unlike EEPROM and associated flash memory which can eventually lose their data by way of charge leakage and tunnelling effects, memory devices pursuant to be present invention are potentially capable of providing long-term permanent data storage, whilst also offering rapid read/write functionality at relatively low power consumption when required. Moreover, the present invention is also potentially capable of providing radiation-hardened memory devices, for example for use in robotic apparatus employed for nuclear decontamination and for nuclear plant decommissioning, for example in respect of Fukushima Dai'ichi nuclear facility, Japan. Furthermore, the present invention is also capable of providing memory devices for use in deep-space satellites which are exposed to high-energy cosmic radiation for lengthy periods when exploring outer space.

Modifications to embodiments of the invention described in the foregoing are possible without departing from the scope of the invention as defined by the accompanying claims. Numerals included within parentheses in the accompanying claims are intended to assist understanding of the claims and should not be construed in any way to limit subject matter claimed by these claims.

### APPENDIX 1

| Earlier document reference | Details of document |
|---|---|
| | |
| Lines & Glass, 1998 | Lines, M. E. and Glass, A. M. (2001), Principles and Applications of Ferroelectrics and Related Materials, Oxford University Press in Oxford Classic Series, ISBN 0-19-850778-X, Oxford |
| Klapper & Hahn, 2005 | Klapper, H. and Hahn, Th. (2005), Point-group Symmetry and Physical Properties of Crystals, In: International Tables for Crystallography A: Space-group Symmetry, Th. Hahn (Ed.), pp. 804-808, Kluwer Academic Publishers, ISBN 0-7923-6590-9, Dordrecht |
| Newnham, 2005 | Newnham, R.E. (2005), Properties of Materials: Anisotropy, Symmetry, Structure, Oxford University Press, ISBN 0-19-852076-X, New York |
| Frantti *et al.* 2003 | Frantti, J; Eriksson, S.; Hull, S.; Lantto, V.; Rundlöf, H. and Kakihana, M. (2003). Composition variation and the monoclinic phase within Pb(ZrxTi1-x)O3 ceramics, J. Phys.: Condens. Matter, Vol. 15, No. 35, pp. 6031-6041 |
| Yokota, 2009 | Yokota, H., Zhang, N., Taylor, A. E., Thomas, P. and Glazer, A.M. (2009), Crystal structure of the rhombohedral phase of PbZr1-x TixO3 ceramics, Phys. Rev. B, Vol. 80, 104109 |
| Sergienko *et al.,* 2002 | Sergienko, I.A.; Gufan, Y.M. and Urazhdin, S. (2002). Phys. Rev. B, Vol. 65, 144104 |
| Jaffe *et al.,* 1970 | Jaffe, B.; Cook, W.R. and Jaffe, H. (1971), Piezoelectric Ceramics, Academic Press, ISBN 0123795508, New York |
| Frantti *et al.,* 2012 | Frantti, J.; Fujioka, Y.; Zhang, J.; Wang, S.; Vogel, S.C.; Nieminen, R.M.; Asiri, A.M.; Zhao, Y.; Obaid, A.Y. and Mkhalid, I.A., High-pressure neutron study of the morphotropic PZT: phase transitions in a two-phase system. J. Appl. Phys., in press. |
| Kittel, 1946 | Kittel, C. (1946), Theory of the Structure of Ferromagnetic Domains in Films and Small Particles, Phys. Rev., Vol. 90, pp. 193-202 |
| Mitsui & Furuichi, 1953 | Mitsui, T. and Furuichi, J. (1953), Domain Structure of Rochelle Salt and KH2PO4. Phys. Rev., Vol. 90, pp. 193-202 |
| Roitburd, 1976 | Roitburd, A.L. (1976), Equilibrium Structure of Epitaxial Layers, Phys, Status Solidi A, Vol. 37, pp. 329-339 |
| Schilling *et al.,* 2006 | Schilling, A.; Adams, T.B.; Bowman, R.M.; Gregg, J.M.; Catalan, G. and Scott, J.F. (2006), Scaling of domain periodicity with thickness measured in BaTiO3 single crystal lamellae and comparison with other ferroics. Phys. Rev. B, Vol. 74, 024115 |
| Streiffer *et al.,* 2002 | Streiffer, S.K.; Eastman, J.A.; Fong, D.D.; Thompson, C.; Munkholm, A.; Ramana Murty, M.V.; Auciello, O.; Bai, G.R. and Stephenson, G.B. (2002), Observation of Nanoscale 180° Stripe Domains in Ferroelectric PbTiO3 Thin Films. Phys. Rev. Lett., Vol. 89, 067601 |
| Pertsev & Zembilgotov, 1995 | Pertsev, N.A. and Zembilgotov, A.G. (1995), Energetics and geometry of 90° domain structures in epitaxial ferroelectric and ferroelastic films. J. Appl. Phys., Vol. 78, pp 6170-6280 |
| Li, 2005 | Li, J.Y.; Rogan, R.C.;Ustündag, E. and Bhattacharya. K. (2005), Domain switching in polycrystalline ferroelectric ceramics. Nature Materials, Vol. 4, pp 776-781 |
| Rogan, 2003 | Rogan, R.C.; Ustündag, E.; Clausen, B. and Daymond, M.R. (2003), Texture and strain analysis of the ferroelastic behaviour of Pb(Zr, Ti)O3 by in situ neutron diffraction. J. Appl. Phys., Vol. 93, No. 7, pp 4104-4111 |
| Frantti, 2013 | Frantti, Y. Fujioka, A. Puretzky, Y. Xie, Z.-G. Ye, and A. M. Glazer (2013), A statistical model approximation for perovskite solid-solutions: A Raman Study of lead-zirconate-titanate singe crystal, in the Journal of Applied Physics, vol. 113, 174104. |
| Takashima | United States granted patent no. US 7057221 B2 |
| Toboyashi | United States patent application no. US 2009/0230211 A1 |
| Ezhilvalavan | PCT patent application no. WO2006/059955A1 |
| Kijima | United States patent application no. US 2005/0072996A1 |
| Argos | United States patent application no.US 5338951A |
| Varshney | PCT patent application no. WO94/05455A2 |
| Park | PCT patent application no. WO2008/082046A1 |
| Hashimoto | Japanese patent application no. JP 2007201051A |
| Roelofs | United States patent application no. US 2007/0041233A1 |
| Yamakawa | United States patent application no. US 2009/0127603A1 |
| Kijima | European patent application no. EP 1557481A2 |
| Kobayashi | United States patent application no. US 2011/0007115A1 |

## Claims

1. A memory device (700) for storing data, wherein the memory device (700) includes at least one memory cell, and wherein the at least one memory cell includes at least one ferroelectric element therein for storing data therein by way of one or more polarization directions of the at least one ferroelectric element and the at least one ferroelectric element comprises a ferroelectric material having a plurality of co-existing phases, wherein the ferroelectric element is fabricated from Lead Zirconate Titanate material whose composition corresponds to a morphotropic phase boundary (MPB) composition,
**characterized in that** the Lead Zirconate Titanate material has a composition Pb(ZrₓTi₁₋ₓ)O₃, wherein a parameter x is in a range of 0.50 to 0.56, wherein the ferroelectric material further comprises a plurality of accessible polarisation states, corresponding to a plurality of spatial directions of polarizations, wherein the polarisation states are greater than 2, and wherein the memory device (700) includes a layer of Gd₃Ga₅O₁₂ between the least one ferroelectric element and a substrate of the memory device (700), further wherein the layer of Gd₃Ga₅O₁₂ is a single crystal material with a <110> crystal orientation exposed at an upper surface of the substrate.

2. A memory device (700) as claimed in claim 1, **characterized in that** the at least one ferroelectric element is provided with an electrode arrangement which enables the at least one ferroelectric element to store a plurality of bits of data.

3. A memory device (700) as claimed in claim 1, **characterized in that** the at least one ferroelectric element has a thickness in a range of 30 nm to 250 nm.

4. A memory device (700) as claimed in claim 3, **characterized in that** the at least one ferroelectric element has a thickness in a range of 50 nm to 150 nm.

5. A method of fabricating a memory device (700) for storing data, wherein the memory device (700) includes at least one memory cell, **characterized in that** said method includes:
(i) fabricating the at least one memory cell to include at least one ferroelectric element therein for storing data therein by way of one or more polarization directions of the at least one ferroelectric element and the at least one ferroelectric element comprises a ferroelectric material having a plurality of co-existing phases,
wherein the ferroelectric element is fabricated from Lead Zirconate Titanate material whose composition corresponds to a morphotropic phase boundary composition, wherein the Lead Zirconate Titanate material is from a composition Pb(ZrₓTi₁₋ₓ)O₃, wherein a parameter x is in a range of 0.50 to 0.56, and
wherein the ferroelectric material further comprises a plurality of accessible polarisation states, corresponding to a plurality of spatial directions of polarizations, wherein the polarisation states are greater than 2, and
wherein the memory device (700) includes a layer of Gd₃Ga₅O₁₂ between the least one ferroelectric element and a substrate of the memory device (700),
further wherein the method includes fabricating the layer of Gd₃Ga₅O₁₂ is a single crystal material with a <110> crystal orientation exposed at an upper surface of the substrate.

6. A method as claimed in claim 5, **characterized in that** the method includes fabricating at least one ferroelectric element to be provided with an electrode arrangement which enables the at least one ferroelectric element to store a plurality of bits of data.

7. A method as claimed in claim 5, **characterized in that** the method includes fabricating the at least one ferroelectric element to have a thickness in a range of 30 nm to 250 nm.

8. A method as claimed in claim 7, **characterized in that** the method includes fabricating the at least one ferroelectric element to have a thickness in a range of 50 nm to 150 nm.

## Patentansprüche

1. Speichervorrichtung (700) zum Speichern von Daten, wobei die Speichervorrichtung (700) mindestens eine Speicherzelle beinhaltet, und wobei die mindestens eine Speicherzelle mindestens ein ferroelektrisches Element beinhaltet, um darin Daten mittels einer oder mehrerer Polarisationsrichtungen des mindestens einen ferroelektrischen Elements zu speichern, und das mindestens eine ferroelektrische Element ein ferroelektrisches Material mit einer Vielzahl von koexistierenden Phasen umfasst, wobei das ferroelektrische Element aus Bleizirkonattitanatmaterial hergestellt ist, dessen Zusammensetzung einer morphotropen Phasengrenz- (MPB)-Zusammensetzung entspricht,
**dadurch gekennzeichnet, dass** das Bleizirkonattitanatmaterial eine Pb(ZrₓTi₁₋ₓ)O3-Zusammensetzung aufweist, wobei ein Parameter x in einem Bereich von 0,50 bis 0,56 liegt, wobei das ferroelektrische Material ferner eine Vielzahl von zugänglichen Polarisationszuständen umfasst, die einer Vielzahl von räumlichen Polarisationsrichtungen entsprechen, wobei die Polarisationszustände größer als 2 sind, und wobei die Speichervorrichtung (700) eine Schicht aus Gd₃Ga₅O₁₂ zwischen dem mindestens einen ferroelektrischen Element und einem Substrat der Speichervorrichtung (700) beinhaltet, ferner wobei die Schicht aus Gd₃Ga₅O₁₂ ein Einkristallmaterial mit einer <110> Kristallorientierung ist, die an einer oberen Oberfläche des Substrats freiliegt.

2. Speichervorrichtung (700) nach Anspruch 1, **dadurch gekennzeichnet, dass** das mindestens eine ferroelektrische Element mit einer Elektrodenanordnung versehen ist, die es dem mindestens einen ferroelektrischen Element ermöglicht, eine Vielzahl von Datenbits zu speichern.

3. Speichervorrichtung (700) nach Anspruch 1, **dadurch gekennzeichnet, dass** das mindestens eine ferroelektrische Element eine Dicke in einem Bereich von 30 nm bis 250 nm aufweist.

4. Speichervorrichtung (700) nach Anspruch 3, **dadurch gekennzeichnet, dass** das mindestens eine ferroelektrische Element eine Dicke in einem Bereich von 50 nm bis 150 nm aufweist.

5. Verfahren zum Herstellen einer Speichervorrichtung (700) zum Speichern von Daten, wobei die Speichervorrichtung (700) mindestens eine Speicherzelle beinhaltet, **dadurch gekennzeichnet, dass** das Verfahren Folgendes beinhaltet:
(i) Herstellen der mindestens einen Speicherzelle, sodass sie mindestens ein ferroelektrisches Element darin beinhaltet, um darin Daten mittels einer oder mehrerer Polarisationsrichtungen des mindestens einen ferroelektrischen Elements zu speichern, und das mindestens eine ferroelektrische Element ein ferroelektrisches Material mit einer Vielzahl von nebeneinander existierenden Phasen umfasst,
wobei das ferroelektrische Element aus Bleizirkonattitanatmaterial hergestellt ist, dessen Zusammensetzung einer morphotropen Phasengrenzzusammensetzung entspricht,
wobei das Bleizirkonattitanatmaterial aus einer Pb(ZrₓTi₁₋ₓ)O3-Zusammensetzung besteht, wobei ein Parameter x in einem Bereich von 0,50 bis 0,56 liegt, und wobei das ferroelektrische Material ferner eine Vielzahl von zugänglichen Polarisationszuständen umfasst, die einer Vielzahl von räumlichen Polarisationsrichtungen entsprechen, wobei die Polarisationszustände größer als 2 sind, und
wobei die Speichervorrichtung (700) eine Schicht aus Gd₃Ga₅O₁₂ zwischen dem mindestens einen ferroelektrischen Element und einem Substrat der Speichervorrichtung (700) beinhaltet,
ferner, wobei das Verfahren das Herstellen der Schicht aus Gd₃Ga₅O₁₂ beinhaltet, die ein Einkristallmaterial mit einer <110> Kristallorientierung ist, die an einer oberen Oberfläche des Substrats freiliegt.

6. Verfahren nach Anspruch 5, **dadurch gekennzeichnet, dass** das Verfahren das Herstellen mindestens eines ferroelektrischen Elements beinhaltet, das mit einer Elektrodenanordnung versehen werden soll, die es dem mindestens einen ferroelektrischen Element ermöglicht, eine Vielzahl von Datenbits zu speichern.

7. Verfahren nach Anspruch 5, **dadurch gekennzeichnet, dass** das Verfahren das Herstellen des mindestens einen ferroelektrischen Elements umfasst, sodass es eine Dicke in einem Bereich von 30 nm bis 250 nm aufweist.

8. Verfahren nach Anspruch 7, **dadurch gekennzeichnet, dass** das Verfahren das Herstellen des mindestens einen ferroelektrischen Elements umfasst, sodass es eine Dicke in einem Bereich von 50 nm bis 150 nm aufweist.

## Revendications

1. Dispositif de mémoire (700) pour le stockage de données, le dispositif de mémoire (700) comportant au moins une cellule de mémoire, et l'au moins une cellule de mémoire comportant dans son intérieur au moins un élément ferroélectrique pour le stockage de données dans son intérieur au moyen d'une ou de plusieurs directions de polarisation de l'au moins un élément ferroélectrique et l'au moins un élément ferroélectrique comprenant un matériau ferroélectrique ayant une pluralité de phases co-existantes, où l'élément ferroélectrique est fabriqué à partir d'un matériau en titanate et zirconate de plomb dont la composition correspond à une composition de limite de phase morphotropique (MPB),
**caractérisé en ce que** le matériau en zirconate et titanate de plomb a une composition Pb(ZrₓTi₁₋ₓ)O₃, où un paramètre x est dans une plage de 0,50 à 0,56, où le matériau ferroélectrique comprend en outre une pluralité d'états de polarisation accessibles, correspondant à une pluralité de directions spatiales de polarisations, où les états de polarisation sont supérieurs à 2, et où le dispositif de mémoire (700) comporte une couche de Gd₃Ga₅O₁₂ entre l'au moins un élément ferroélectrique et un substrat du dispositif de mémoire (700), la couche de Gd₃Ga₅O₁₂ étant en outre un matériau monocristallin avec une orientation cristalline <110> exposée au niveau d'une surface supérieure du substrat.

2. Dispositif de mémoire (700) selon la revendication 1, **caractérisé en ce que** l'au moins un élément ferroélectrique est pourvu d'un agencement d'électrodes qui permet à l'au moins un élément ferroélectrique de stocker une pluralité de bits de données.

3. Dispositif de mémoire (700) selon la revendication 1, **caractérisé en ce que** l'au moins un élément ferroélectrique a une épaisseur dans une plage de 30 nm à 250 nm.

4. Dispositif de mémoire (700) selon la revendication 3, **caractérisé en ce que** l'au moins un élément ferroélectrique a une épaisseur dans une plage de 50 nm à 150 nm.

5. Procédé de fabrication d'un dispositif de mémoire (700) pour le stockage de données, le dispositif de mémoire (700) comportant au moins une cellule de mémoire, **caractérisé en ce que** ledit procédé comprend :
(i) la fabrication de l'au moins une cellule de mémoire pour qu'elle comporte au moins un élément ferroélectrique dans son intérieur pour le stockage de données dans son intérieur au moyen d'une ou de plusieurs directions de polarisation de l'au moins un élément ferroélectrique et l'au moins un élément ferroélectrique comprend un matériau ferroélectrique ayant une pluralité de phases co-existantes,
l'élément ferroélectrique étant fabriqué à partir d'un matériau en zirconate et titanate de plomb dont la composition correspond à une composition de limite de phase morphotropique,
le matériau en zirconate et titanate de plomb ayant une composition Pb(ZrₓTi₁₋ₓ)O₃, un paramètre x étant dans une plage de 0,50 à 0,56, et
le matériau ferroélectrique comprenant en outre une pluralité d'états de polarisation accessibles, correspondants à une pluralité de directions spatiales de polarisations, les états de polarisation étant supérieurs à 2, et
le dispositif de mémoire (700) comportant en outre une couche de Gd₃Ga₅O₁₂ entre l'au moins un élément ferroélectrique et un substrat du dispositif de mémoire (700),
le procédé comportant en outre la fabrication de la couche de Gd₃Ga₅O₁₂ sous forme d'un matériau monocristallin avec une orientation cristalline <110> exposée au niveau d'une surface supérieure du substrat.

6. Procédé selon la revendication 5, **caractérisé en ce que** le procédé comporte la fabrication d'au moins un élément ferroélectrique pour qu'il soit pourvu d'un agencement d'électrodes qui permet à l'au moins un élément ferroélectrique de stocker une pluralité de bits de données.

7. Procédé selon la revendication 5, **caractérisé en ce que** le procédé comporte la fabrication de l'au moins un élément ferroélectrique pour qu'il ait une épaisseur dans une plage de 30 nm à 250 nm.

8. Procédé selon la revendication 7, **caractérisé en ce que** le procédé comporte la fabrication de l'au moins un élément ferroélectrique pour qu'il ait une épaisseur dans une plage de 50 nm à 150 nm
